(19) Europäisches Patentamt
European Patent Office
Office européen des brevets

(11) **EP 1 145 445 B1**

(12) **EUROPÄISCHE PATENTSCHRIFT**

(45) Veröffentlichungstag und Bekanntmachung des Hinweises auf die Patenterteilung:
**12.06.2002 Patentblatt 2002/24**

(21) Anmeldenummer: 00904817.4

(22) Anmeldetag: 03.01.2000

(51) Int Cl.⁷: **H03M 13/29**, H04L 25/03

(86) Internationale Anmeldenummer:
**PCT/DE00/00019**

(87) Internationale Veröffentlichungsnummer:
**WO 00/44100 (27.07.2000 Gazette 2000/30)**

(54) **VERFAHREN UND VORRICHTUNG ZUR DECODIERUNG VON FALTUNGSCODES**

METHOD AND DEVICE FOR DECODING CONVOLUTION CODES

DISPOSITIF ET PROCEDE DE DECODAGE DE CODES DE CONVOLUTION

(84) Benannte Vertragsstaaten:
**AT BE CH CY DE DK ES FI FR GB GR IE IT LI LU MC NL PT SE**

(30) Priorität: **20.01.1999 DE 19902100**

(43) Veröffentlichungstag der Anmeldung:
**17.10.2001 Patentblatt 2001/42**

(73) Patentinhaber: **Infineon Technologies AG**
**81669 München (DE)**

(72) Erfinder:
• **DOETSCH, Markus**
**D-81539 München (DE)**
• **JUNG, Peter**
**D-67697 Otterberg (DE)**
• **PLECHINGER, Jörg**
**D-80469 München (DE)**
• **SCHMIDT, Peter**
**D-67167 Erpolzheim (DE)**

(74) Vertreter: **Graf Lambsdorff, Matthias, Dr.**
**Patentanwälte**
**Lambsdorff & Lange**
**Dingolfinger Strasse 6**
**81673 München (DE)**

(56) Entgegenhaltungen:
• **RAPHAELI ET AL: "Combined turbo equalization and turbo decoding" GLOBAL TELECOMMUNICATIONS CONFERENCE (GLOBECOM),US,NEW YORK, IEEE,1997, Seiten 639-643, XP002080195 ISBN: 0-7803-4199-6**
• **JUNG P: "NOVEL LOW COMPLEXITY DECODER FOR TURBO CODES" ELECTRONICS LETTERS , Bd. 31, Nr. 2, 19. Januar 1995 (1995-01-19), Seiten 86-87, XP002137715**
• **HAGENAUER J: "SOURCE-CONTROLLED CHANNEL DECODING" IEEE TRANSACTIONS ON COMMUNICATIONS,US,IEEE INC. NEW YORK, Bd. 43, Nr. 9, 1. September 1995 (1995-09-01), Seiten 2449-2457, XP000525669 ISSN: 0090-6778**
• **BERROU C ET AL: "NEAR OPTIMUM ERROR CORRECTING CODING AND DECODING: TURBO-CODES" IEEE TRANSACTIONS ON COMMUNICATIONS,US,IEEE INC. NEW YORK, Bd. 44, Nr. 10, 1. Oktober 1996 (1996-10-01), Seiten 1261-1271, XP000629465 ISSN: 0090-6778**
• **JUNG P ET AL: "COMPREHENSIVE COMPARISON ON TURBO-CODE DECODERS" PROCEEDINGS OF THE VEHICULAR TECHNOLOGY CONFERENCE,US,NEW YORK, IEEE, Bd. CONF. 45, 1995, Seiten 624-628, XP000551609 ISBN: 0-7803-2743-8**
• **JUNG P: "COMPARISON OF TURBO-CODE DECODERS APPLIED TO SHORT FRAME TRANSMISSION SYSTEMS" IEEE JOURNAL ON SELECTED AREAS IN COMMUNICATIONS,US,IEEE INC. NEW YORK, Bd. 14, Nr. 3, 1. April 1996 (1996-04-01), Seiten 530-537, XP000586080 ISSN: 0733-8716**

**Beschreibung**

Die Erfindung betrifft ein Verfahren und eine Vorrichtung zur Decodierung von Faltungscodes.

In Kommunikationssystemen, beispielsweise. Mobilfunksystemen wird das zu übertragende Signal (beispielsweise Sprachsignal) nach Aufbereitung in einem Quellencodierer einer Kanalcodierung unterzogen. Die Kanalcodierung dient dazu, das zu übertragende Signal an die Eigenschaften des Übertragungskanals anzupassen. Dabei wird durch gezieltes Einbringen von Redundanz in das zu übertragende Signal ein effektiver Fehlerschutz erreicht.

Erst seit wenigen Jahren werden zur Kanalcodierung binäre parallel verkettete rekursive Faltungscodes untersucht. Für diese Faltungscodes hat sich die Bezeichnung "Turbo-Codes" eingebürgert. Insbesondere bei der Übertragung großer Blöcke mit mehr als eintausend Bits (Symbolen) kann mit Turbo-Codes ein erheblich besserer Fehlerschutz als mit der (üblichen) Faltungscodierung erzielt werden. Nachteilig ist jedoch, daß die Decodierung von Turbo-Codes aufwendiger ist als die Decodierung von (üblichen) Faltungscodes.

Es ist bereits bekannt, zur Decodierung von Turbo-Codes einen iterativen Turbo-Decodierer einzusetzen, der zwei einzelne Faltungsdecodierer enthält, die rückkopplungsartig miteinander verschaltet sind. Zumindest der eingangsseitig vorgesehene Faltungsdecodierer muß eine "weiche" Decodierung (soft decoding) ermöglichen, d.h. in der Lage sein, bei jedem empfangenen Datensymbol zusätzlich oder anstelle eines binären Ausgangswertes einen wertekontinuierlichen Schätzwert für das dem empfangenen Datensymbol zugrundeliegende ursprüngliche, uncodierte Datensymbol zu bestimmt. Für iterative Turbo-Decodierer ist charakteristisch, daß diese wertekontinuierlichen Schätzwerte dem zweiten Faltungsdecodierer im Rahmen der Iteration als Eingangsinformation zugeführt werden. Schätzwerte für ursprüngliche, **uncodierte** Datensymbole werden im folgenden auch als erste Zuverlässigkeitsinformation bezeichnet.

In dem Artikel "Near Shannon Limit Error - Correcting, Coding and Decoding: Turbo-codes (1)" von C. Berrou et al., Proc. IEEE Int. Conf. on Communications ICC'93, Genua, 1993, Seiten 1064 bis 1070 ist ein iterativer Turbo-Decodierer beschrieben, dessen eingangsseitiger Faltungsdecodierer zur Erzeugung der ersten Zuverlässigkeitsinformation nach einem modifizierten BAHL et al.-Algorithmus arbeitet. Der zweite Faltungsdecodierer, der keine Zuverlässigkeitsinformation erzeugen muß, kann beispielsweise nach dem bekannten VITERBI-Algorithmus arbeiten.

Faltungsdecodierer, die nach einem symbolweisen MAP- (Maximum a-Posteriori)-Algorithmus arbeiten, sind ebenfalls in der Lage, erste Zuverlässigkeitsinformation zu erzeugen. Solche Faltungsdecodierer werden als MAP-Symbolschätzer (oder auch MAP-Symboldecodierer) bezeichnet. Sie weisen den Vorteil auf, daß mit ihnen das geringstmögliche Bitfehlerverhältnis erreicht werden kann.

Eine detaillierte Beschreibung eines iterativen Turbo-Decodierers mit zwei rekursiv verschalteten MAP-Symbolschätzern ist in dem Buch "Analyse und Entwurf digitaler Mobilfunksysteme", von P. Jung, Stuttgart, B.G. Teubner, 1997 auf den Seiten 343 - 368, insbesondere Bild E.2 angegeben.

Bei Mobilfunkanwendungen tritt das Problem auf, daß der Mobilfunkkanal in starkem Maße zeitvariant ist, d. h. daß sich seine Übertragungseigenschaften aufgrund wechselnder Umgebungseinflüsse ständig ändern. Die ständigen Änderungen der Übertragungseigenschaften des Mobilfunkkanals müssen bereits bei der Datendetektion berücksichtigt werden. Zu diesem Zweck weist ein im Mobilfunk eingesetztes Kommunikationsendgerät einen mit dem Datendetektor gekoppelten Kanalschätzer auf, der fortlaufend die Übertragungseigenschaften (Impulsantworten) des Mobilfunkkanals ermittelt und dem Datendetektor mitteilt. Eine solche, die momentanen Übertragunskanaleigenschaften berücksichtigende Datendetektion wird als adaptive Datendetektion oder adaptive Entzerrung bezeichnet.

Die Zeitvarianz des Mobilfunkkanals beeinflußt aber auch die hinter der adaptiven Entzerrung stattfindende Decodierung. In diesem Zusammenhang ist nachteilig, daß der durch eine Turbo-Decodierung prinzipiell erreichbare hohe Fehlerschutzgrad durch die Zeitvarianz des Mobilfunkkanals zumindest teilweise wieder zunichte gemacht wird.

In dem Artikel "Combined Turbo Equalization and Turbo Decoding", von D. Raphaeli und Y. Zarai, IEEE Communications Letters, Bd. 2, Nr. 4, 1998, Seiten 107 - 109 ist eine iterative Empfängerstruktur beschrieben, die aus einer Kombination eines adaptiven Entzerrers und eines diesem nachgeschalteten (iterativen) Turbo-Decodierers aufgebaut ist. Als Schlagwort für eine solche kombinierte Empfängerstruktur hat sich der Begriff "Turbo-Entzerrung" ("Turbo-Equalization") gebildet. Der iterative Turbo-Decodierer ist auch hier wiederum aus zwei MAP-Symboldecodierern aufgebaut. Die beiden MAP-Symboldecodierer, die in diesem Artikel als MAP-Blöcke bezeichnet werden, berechnen neben der ersten Zuverlässigkeitsinformation auch eine zweite Zuverlässigkeitsinformation. Die zweite Zuverlässigkeitsinformation stellt einen wertekontinuierlichen Schätzwert für das dem detektierten Datensymbol zugrundeliegende ursprüngliche, **codierte** Datensymbol dar.

Die Kopplung zwischen adaptiver Entzerrung und Datendecodierung wird dadurch realisiert, daß der iterative Turbo-Decodierer bei jedem Iterationsschritt aus den zweiten Zuverlässigkeitsinformationen der beiden Faltungsdecodierer eine kombinierte Zuverlässigkeitsinformation erzeugt, die er dem adaptiven Entzerrer als extrinsische (d.h. nicht im Entzerrer selbst erzeugte) Information zukommen läßt, und daß der adaptive Entzerrer seinerseits extrinsische Information in den Turbo-Decodierer einspeist. Durch diese Rückkopplung zwischen Entzerrer und Turbo-Decodierer läßt sich die Zeitvarianz des Mobilfunkkanals bei der Turbo-Decodierung berücksichtigen. Nachteilig ist jedoch, daß der bei einer Turbo-Decodierung ohnehin schon hohe Rechenaufwand durch die Miteinbeziehung des Entzerrers in den Iterationsablauf noch wesentlich erhöht wird.

In dem Artikel "Novel low complexity decoder for turbo-codes" von P. Jung, Electronics Letters, Bd. 31, Nr. 2, 1995, S. 86 bis 87, wird eine vereinfachte Version eines iterativen Turbo-Decodierers für die Decodierung von Turbo-Codes vorgeschlagen. Dieser Turbo-Decodierer unterscheidet sich von den bis dahin bekannten Turbo-Decodierern dadurch, daß die beiden im Turbo-Decodierer enthaltenen Faltungsdecodierer nach einem neuartigen sogenannten SUBMAP-Algorithmus arbeiten, der bei einer vertretbaren Verschlechterung der Decodierleistung (d.h. Erhöhung des Bitfehlerverhältnisses) eine wesentliche Einsparung an Rechenaufwand bei der Berechnung der ersten Zuverlässigkeitsinformation ermöglicht.

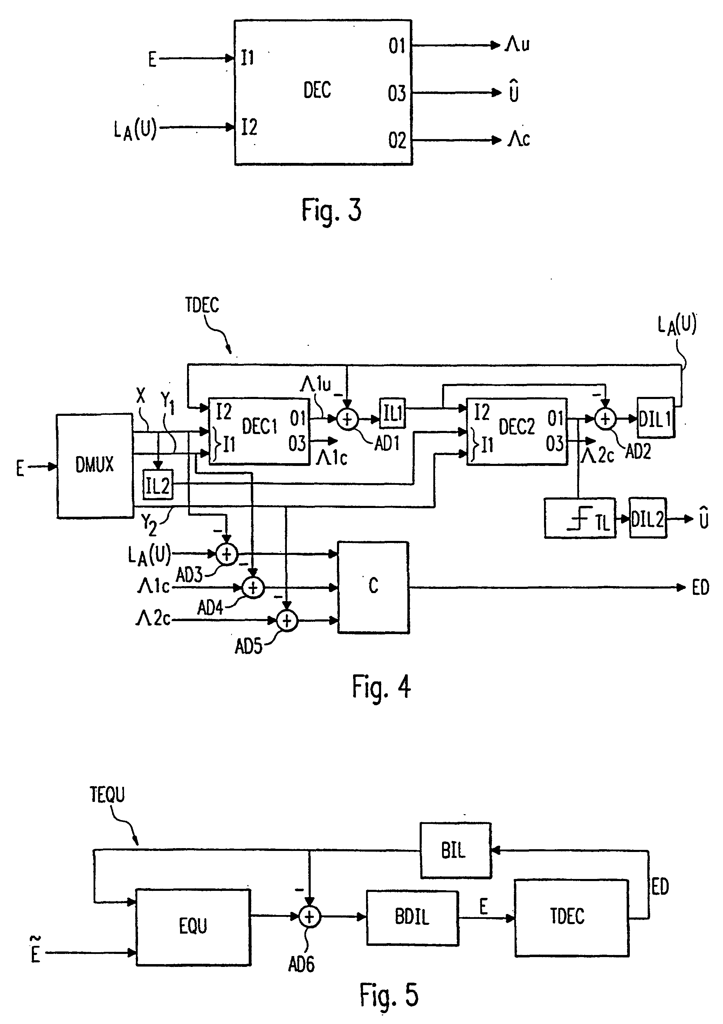

In der Veröffentlichung "Combined turbo equalization and turbo decoding", Global Telecommunications Conference (GLOBE-COM), US, New York, IEEE, 1997, Seiten 639-643, XP00208195 ISBN: 0-7803-4199-6 von Raphaeli et al., wird eine Decoderstruktur beschrieben, in welcher gemäß der Fig. 3 und dem dort dargestellten Eingang C1 des Code-MAP eine Folge von empfangenen codierten Symbolen entgegengenommen wird, gemäß der Fig. 3 und dem darin dargestellten Ausgang L des Code-MAP Blocks eine erste Zuverlässigkeitsinformation für jedes unkodierte Symbol berechnet wird, und gemäß der Fig. 3 und dem darin dargestellten Ausgang F des Code-MAP Blocks eine zweite Zuverlässigkeitsinformation für jedes codierte Symbol berechnet wird. Bezüglich der Ermittlung der zweiten Zuverlässigkeitsinformation wird in dieser Publikation auf die bekannten MAP-Decoder verwiesen.

Die Publikation "Source-controlled Channel Decoding" in IEEE Transactions on Communications, US, IEEE INC. New York, Bd. 43, Nr. 9, 1. September 1995 (1995-09-01), Seiten 2449-2457, XP000525669 ISSN: 0090-6778 von J. Hagenauer, wird eine bestimmte Modifikation des Viterbi-Decodieralgorithmus für binäre Trellis-Diagramme vorgeschlagen. Die Berechnung einer zweiten Zuverlässigkeitsinformation wird hierbei jedoch nicht in Betracht gezogen.

Die Publikation "Comprehensive Comparison on Turbo-Code Decoders" in Proceedings of the Vehicular Technology Conference, US, New York, IEEE, Bd. CONF. 45, 1995, Seiten 624-628, XP000551609 ISBN: 0-7803-2743-8, von P. Jung et al. offenbart einen SUB-MAPSSE-Decoder, in welchem zweite Zuverlässigkeitsinformation in aufwandsgünstiger Weise bestimmt werden kann.

Der Erfindung liegt die Aufgabe zugrunde, ein Verfahren zur Erzeugung von zweiter Zuverlässigkeitsinformation für codiert übertragene Symbole am Ausgang eines Faltungsdecodierers anzugeben. Insbesondere soll das Verfahren eine aufwandsgünstige Decodierung eines Faltungscodes in einer Empfängerstruktur aus kombiniertem Entzerrer und Turbo-Decodierer ermöglichen. Ferner zielt die Erfindung darauf ab, einen Faltungsdecodierer zu schaffen, der zweite Zuverlässigkeitsinformation für codiert übertragene Symbole bereitstellt und insbesondere zur Realisierung der genannten kombinierten Empfängerstruktur eingesetzt werden kann.

Die Lösung der Aufgabe wird durch die Merkmale des Anspruchs 1 angegeben. Ferner wird die Aufgabenstellung durch die Merkmale des Anspruchs 6 gelöst.

Erfindungsgemäß wird die zweite Zuverlässigkeitsinformation im wesentlichen durch die Ermittlung des Maximalwertes von codeabhängigen Produkttermen der ersten Zuverlässigkeitsinformation bestimmt. Diese Vorgehensweise ist besonders bequem, da allein die bereits ermittelte erste Zuverlässigkeitsinformation zur Berechnung der zweiten Zuverlässigkeitsinformation herangezogen werden muß. Ermöglicht wird dies durch die Eigenschaft eines codierten Symbols, sich als (von dem speziellen Code abhängige) Summe über uncodierte Symbole darstellen zu lassen.

Es kann die erste Zuverlässigkeitsinformation grundsätzlich nach einem beliebigen Algorithmus, beispielsweise dem MAP-Algorithmus berechnet werden. Eine aufwandsgünstige Berechnung der ersten Zuverlässigkeitsinformation wird durch die Merkmale des Anspruchs 2 erreicht.

Sofern a-priori-Wissen über die Folge der uncodierten Symbole vorhanden ist, wird dieses zweckmäßigerweise in die Bestimmung der ersten und/oder zweiten Zuverlässigkeitsinformation einbezogen.

Ein nach einem der genannten Verfahren arbeitender Faltungsdecodierer ist in Anspruch 5 angegeben.

Neben dem ersten Ausgang für die erste Zuverlässigkeitsinformation und dem zweiten Ausgang für die zweite Zuverlässigkeitsinformation umfaßt der Faltungsdecodierer vorzugsweise einen dritten Ausgang, an dem für jedes uncodierte Symbol ein "harter", d.h. in dem Symbolvorrat (im binären Fall: 0, 1) enthaltener Schätzwert bereitgestellt wird.

Aufgrund seiner rechenaufwandsgünstigen Bereitstellung der zweiten Zuverlässigkeitsinformation kann der erfindungsgemäße Faltungsdecodierer mit Vorteil in einem Turbo-Decodierer eingesetzt werden, welcher eine kombinierte Zuverlässigkeitsinformation bereitstellt, die aus zweiter Zuverlässigkeitsinformation eines ersten und eines zweiten Faltungsdecodierers gebildet ist.

Zur Realisierung einer "Turbo-Entzerrung" ist ein derartiger Turbo-Decodierer rückkopplungsmäßig mit einem Entzerrer verschaltet, derart, daß die kombinierte Zuverlässigkeitsinformation einem Eingang des Entzerrers zugeführt ist. Aufgrund der erfindungsgemäßen vereinfachten Berechnung der kombinierten Zuverlässigkeitsinformation wird eine "Turbo-Entzerrung" ermöglicht, deren Rechenaufwand für praktische Anwendungen hinreichend gering ist.

Weitere bevorzugte Ausgestaltungen der Erfindung sind in den Unteransprüchen angegeben.

Die Erfindung wird nachfolgend anhand eines Ausführungsbeispiels unter Bezugnahme auf die Zeichnung beschrieben. In dieser zeigt:

Fig. 1  ein Blockschaltbild eines Turbo-Codierers zur Erzeugung eines Turbo-Codes;

Fig. 2  ein Blockschaltbild eines RSC-Faltungscodierers aus Fig. 1;

Fig. 2a  ein Blockschaltbild eines nicht-rekursiven Faltungscodierers;

Fig. 3  ein Blockschaltbild eines Faltungsdecodierers gemäß der Erfindung;

Fig. 4  ein Blockschaltbild eines Turbo-Decodierers, der den in Fig. 3 dargestellten Faltungsdecodierer verwendet; und

Fig. 5  ein Blockschaltbild einer erfindungsgemäßen iterativen Empfängerstruktur bestehend aus einer Kombination eines Entzerrers mit dem Turbo-Decodierer aus Fig. 4.

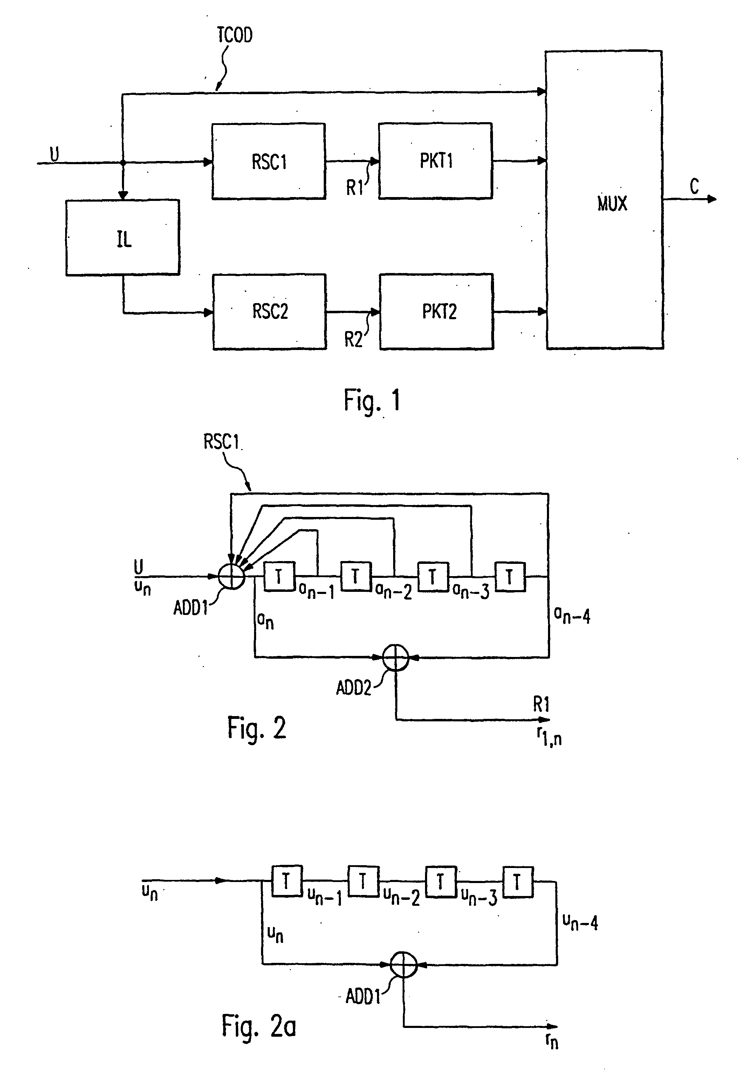

Vor der Beschreibung eines erfindungsgemäßen Faltungsdecodierers (Fig. 3) wird zum besseren Verständnis der Erfindung zunächst anhand von Fig. 1 ein Turbo-Codierer TCOD für Turbo-Codes beschrieben.

Der Turbo-Codierer TCOD weist zwei identische binäre rekursive systematische Faltungscodierer RSC1 und RSC2 auf, die in der Codiertechnik als RSC-(Recursive Systematic Convolutional-) Codierer bekannt sind. Dem zweiten Faltungscodierer RSC2 ist eingangsseitig ein Turbo-Code-Verschachteler IL vorgeschaltet, und die Ausgänge der beiden Faltungscodierer RSC1 und RSC2 sind jeweils über Punktierer PKT1 bzw. PKT2 mit einem Multiplexer MUX verbunden.

Mit

$$U = (u_1, ..., u_N) \tag{1}$$

wird eine Folge von uncodierten Symbolen am Eingang des Turbo-Codierers TCOD bezeichnet. Die Folge U besteht aus einer endlichen Anzahl N von Symbolen, die im folgenden zur einfacheren Darstellung mit Bits identifiziert werden, d.h. $u_n = 0$ oder 1 für alle n = 1, 2, ..., N. U wird im folgenden als Eingangsfolge und N als Blockgröße der Eingangsfolge bezeichnet.

Von beiden RSC-Faltungscodierern RSC1 und RSC2 wird Redundanz erzeugt, die durch die Redundanzteilfolgen R1 und R2 mit jeweils N binären Gliedern

$$R1 = (r_{1,1}, ..., r_{1,N})$$

$$R2 = (r_{2,1}, ..., r_{2,N}) \tag{2}$$

dargestellt wird.

Die Redundanzteilfolgen R1 und R2 werden von den Punktierern PKT1 bzw. PKT2 punktiert, und die Eingangsfolge U sowie die punktierten Folgen R1 und R2 werden dem Multiplexer MUX zugeführt. Dieser erzeugt an seinem Ausgang eine Ausgangsfolge

$$C = (c_1, ..., c_K) \tag{3}$$

die eine Anzahl K von codierten binären Symbolen umfaßt.

Das Verhältnis $R_c = N/K$ wird als Coderate $R_c$ bezeichnet und ist ein Maß für die im Turbo-Codierer hinzugefügte Redundanz. Im folgenden wird ein Turbo-Code mit der Coderate $R_c = 1/2$ betrachtet. Die Ausgangsfolge C umfaßt dann doppelt so viele Bits wie die Eingangsfolge U.

Ist die Blockgröße N eine gerade Zahl, erzeugen die Punktierer PKT1 und PKT2 und der Multiplexer MUX die Ausgangsfolge C beispielsweise nach der folgenden Vorschrift:

$$c_{2n-1} = u_n \qquad n = 1, ..., N$$

$$c_{4n-2} = r_{1,2n-1} \qquad n = 1, ..., N/2$$

$$c_{4n} = r_{2,2n} \qquad n = 1, ..., N/2 \tag{4}$$

Für N = 4 ergibt sich dann die Ausgangsfolge C des Turbo-Codierers TCOD in der Form

$$C = (u_1, r_{1,1}, u_2, r_{2,2}, u_3, r_{1,3}, u_4, r_{2,4}) \tag{5}$$

Bei dem in Fig. 1 gezeigten Turbo-Codierer TCOD ist die Eingangsfolge $U = (u_1, ..., u_N)$ vollständig in der codierten Ausgangsfolge C enthalten (siehe Gl. 5). Codes mit dieser Eigenschaft werden als systematische Codes bezeichnet.

Die restlichen N Symbole der Ausgangsfolge C sind Redundanz, die abwechselnd auf die Redundanzteilfolgen R1 und R2 zurückgeht. Diese Redundanz kann in der Redundanzfolge R

$$R = (r_1, ...., r_N) \tag{6}$$

zusammengefaßt werden. Für das obige Beispiel gilt $r_1 = r_{1,1}$, $r_2 = r_{2,2}$, $r_3 = r_{1,3}$, $r_4 = r_{2,4}$.

Die Ausgangsfolge C mit K = 2N Gliedern ist also alternierend aus N Gliedern der Eingangsfolge U und mit N Gliedern der Redundanzfolge R aufgebaut.

Die Ausgangsfolge C wird in nicht dargestellter Weise anschließend blockverschachtelt, in geeignete Datenpakete (Bursts) unterteilt, moduliert, in Sendeverstärkern verstärkt und abgestrahlt.

Fig. 2 zeigt ein Blockschaltbild eines RSC-Codierers, wie er in Fig. 1 für RSC1 und/oder RSC2 eingesetzt werden kann. Der RSC-Codierer RSC1 weist eingangsseitig einen ersten Addierer ADD1 und ein dem Addierer ADD1 nachgeschaltetes Schieberegister mit 4 Zellen T auf. Die Redundanzteilfolge R1 wird von einem zweiten Addierer ADD2 gebildet, der den Eingangs- und den Ausgangswert des Schieberegisters addiert. Es wird deutlich, daß ein zu einem bestimmten Zeitpunkt am Ausgang des RSC-Codierers RSC1 vorliegendes Redundanzbit $r_{1,n}$ der Redundanzteilfolge R1 von dem aktuellen Eingangsbit $u_n$ der Folge U von uncodierten Symbolen sowie von dem Zustand des Schieberegisters abhängt. Der Zustand des Schieberegisters hängt wiederum von den letzten 4 Eingangsbits ab. Als Rückgriffstiefe L wird die Anzahl von Binärzeichen (Symbolen) bezeichnet, die bei ADD1 für eine Verknüpfung zur Verfügung stehen, d.h. hier 5.

Die Erzeugung der Redundanzteilfolge R1 aus einer Folge U von uncodierten Symbolen läßt sich unmittelbar anhand der Darstellung der Fig. 2 verfolgen. Die Ausgangsfolge C des Turbo-Codierers TCOD folgt dann aus Gl. 4. Alternativ kann zur Ermittlung von R1 (bzw. C) auch ein in der Codiertechnik als Trellis-Diagramm bezeichnetes Zustandsdiagramm des RSC1-(bzw. TCOD-) Codierers herangezogen werden. Das Trellis-Diagramm des RSC1-Codierers mit einem Schieberegister aus 4 Zellen weist $M_T = 2^4$ Knoten auf, die den möglichen Zuständen des Schieberegisters entsprechen. Ein (beliebiger) erster Zustand m, der durch Eingabe eines Eingangsbits (u = 0 oder 1) in einen zweiten Zustand m' übergeht, ist mit diesem im Trellis-Diagramm durch eine Verbindungslinie verbunden. Jede Redundanzteilfolge R1 entspricht dann einem bestimmten Weg entlang Verbindungslinien durch das Trellis-Diagramm des RSC1-Codierers.

Trellis-Diagramme zur Veranschaulichung der Zustände von Codierern sind bekannt und werden hier nicht näher erläutert.

Fig. 3 zeigt eine schematische Darstellung eines Faltungsdecodierers DEC gemäß der vorliegenden Erfindung.

Zunächst werden die Eingänge und Ausgänge von DEC beschrieben:

An einem ersten Eingang I1 des DECs liegt eine Empfangsfolge

$$E = (e_1, ..., e_K) \tag{7}$$

an, die aus K komplexwertigen Abtastwerten besteht, welche gestörte Versionen der codierten Symbole $c_1$ bis $c_K$ der Ausgangsfolge C sind.

Entsprechend dem Aufbau der Ausgangsfolge C umfaßt die Empfangsfolge E eine systematische Empfangs-

folge

$$X = (x_1, ..., x_N), \tag{8}$$

welche die gestörte systematische Information der Folge U enthält, und eine Redundanz-Empfangsfolge

$$Y = (y_1, ..., y_N), \tag{9}$$

welche die gestörte Redundanz der Redundanzfolge R (siehe Gl. 6) enthält.

Da gemäß Gl. 5 und 6 die einzelnen Werte $y_n$ abwechselnd auf die von dem ersten RSC-Codierer RSC1 erzeugte Redundanz $r_{1,n}$ und die von dem zweiten RSC-Codierer RSC2 erzeugte Redundanz $r_{2,n}$ zurückgeht, kann Y auch als

$$Y = (y_{1,1}, y_{2,2}, y_{1,3}, y_{2,4}, ...) \tag{10}$$

d.h. in der Form Y = Y1 + Y2 mit den beiden Redundanz-Empfangsteilfolgen Y1 und Y2

$$Y1 = (y_{1,1}, 0, y_{1,3}, 0, ...) \tag{10a}$$

$$Y2 = (0, y_{2,2}, 0, y_{2,4}, ...) \tag{10b}$$

geschrieben werden.

Wie im folgenden (Fig. 4) noch näher erläutert, muß an dem ersten Eingang I1 nicht die gesamte Empfangsfolge E anliegen sondern je nach Anwendungsfall können beispielsweise nur die Folgen X, Y1 oder X, Y2 anliegen.

An einem zweiten (optionalen) Eingang I2 des DECs kann eine Folge $L_A(U)$ anliegen, die a-priori-Wissen über die uncodierten Symbole $u_1$ bis $u_N$ enthält. Die Folge $L_A(U)$ kann geschrieben werden als
$L_A(U) = (L_A(u_1), ..., L_A(u_N))$, wobei
die einzelnen Glieder im binären Fall in Form eines logarithmischen Verhältnisses definiert sein können:

$$L_A(u_n) = \log\left\{\frac{P(u_n = 1)}{P(u_n = 0)}\right\} \qquad \text{für } n = 1, ..., N. \tag{11}$$

$P(u_n = 1)$ und $P(u_n = 0)$ bezeichnen dabei die Wahrscheinlichkeiten, daß $u_n$ gleich 1 bzw. gleich 0 ist. Sind diese beiden Ereignisse stets (d.h. für alle n = 1, ..., N) gleichwahrscheinlich, ergibt sich beispielsweise $L_A(U) = (0, ..., 0)$.

An einem ersten Ausgang O1 des DECs wird erste Zuverlässigkeitsinformation bereitgestellt.

Mit erster Zuverlässigkeitsinformation werden die bedingten Wahrscheinlichkeiten $P(u_n = 1|E)$ bzw. $P(u_n = 0|E)$ dafür bezeichnet, daß das Symbol $u_n$ gleich 1 bzw. gleich 0 ist unter der Bedingung, daß die Empfangsfolge E vorliegt. Diese bedingten Wahrscheinlichkeiten sind "Wahrscheinlichkeiten a posteriori", da von einem eingetretenen Ereignis (der detektierten Empfangsfolge E) auf die Wahrscheinlichkeiten der diesem Ereignis zugrundeliegenden **uncodierten** $u_1$ bis $u_N$ rückgeschlossen wird.

Im binären Fall kann die erste Zuverlässigkeitsinformation als Folge $\Lambda_U$ mit

$$\Lambda_U = (\Lambda(u_1), ..., \Lambda(u_N)) \tag{12}$$

aus N komplexwertigen Gliedern $\Lambda(u_n)$, n = 1, ..., N dargestellt werden. Die Folgenglieder $\Lambda(u_n)$ lassen sich als das logarithmische Verhältnis der bedingten Wahrscheinlichkeiten

$$\Lambda(u_n) = \log\left\{\frac{P(u_n = 1|E)}{P(u_n = 0|E)}\right\} \tag{13}$$

schreiben und können als wertekontinuierliche a-posteriori Schätzwerte für die uncodierten Datensymbole $u_1$ bis $u_N$ der Eingangsfolge U aufgefaßt werden.

Bei zusätzlichem Vorliegen von a-priori-Wissen $L_A(U)$ über die uncodierten Symbole $u_1, ..., u_N$ kann dieses entsprechend den bedingten Wahrscheinlichkeiten $P(u_n = 1|E, L_A(U))$ bzw. $P(u_n = 0|E, L_A(U))$ in die Berechnung der ersten Zuverlässigkeitsinformation einbezogen werden.

An einem zweiten Ausgang 02 des DECs wird zweite Zuverlässigkeitsinformation bereitgestellt.

Mit zweiter Zuverlässigkeitsinformation werden die bedingten Wahrscheinlichkeiten $P(c_k = 1|E)$ bzw. $P(c_k = 0|E)$ dafür bezeichnet, daß das codierte Symbol $c_k$ gleich 1 bzw. gleich 0 ist unter der Bedingung, daß die Empfangsfolge E vorliegt. Bei zusätzlichem Vorliegen von a-priori-Wissen $L_A(U)$ über die uncodierten Symbole $u_1, ..., u_N$ können auch die entsprechenden bedingten Wahrscheinlichkeiten $P(c_k = 1|E, L_A(U))$ bzw. $P(c_k = 0|E, L_A(U))$ betrachtet werden.

Im binären Fall ist die zweite Zuverlässigkeitsinformation ähnlich der ersten als Folge $\Lambda_C$ aus K komplexwertigen Gliedern $\Lambda(c_k)$, k = 1, ..., K darstellbar.

$$\Lambda_C = (\Lambda(c_1), ..., \Lambda(c_K)) \tag{14}$$

Die Folgenglieder $\Lambda(c_k)$ sind a-posteriori Schätzwerte für die codierten Datensymbole $c_1$ bis $c_K$. Sie lassen sich in der zuvor erläuterten Notation folgendermaßen schreiben:

$$\Lambda(c_k) = \log\left\{\frac{P(c_k = 1|E)}{P(c_k = 0|E)}\right\}, \qquad k = 1, ..., K \tag{15}$$

Wie bereits erwähnt, kann anstelle der Empfangsfolge E auch lediglich eine Empfangs-Teilfolge (beispielsweise X und Y1) am ersten Eingang I1 von DEC anliegen. In diesem Fall ist in den obigen Gleichungen die Empfangsfolge E durch die entsprechende Teilfolge (X und Y1) zu ersetzen. Ferner wird darauf hingewiesen, daß die zweite Zuverlässigkeitsinformation im Regelfall nicht für alle K Glieder von $c_k$ berechnet werden muß. Bei einem systematischen Code muß die zweite Zuverlässigkeitsinformation beispielsweise maximal für die in C enthaltene Redundanz R (N-Glieder), d.h. $\Lambda(r_n)$ bestimmt werden. Darüber hinaus ist zu bemerken, daß die erste und zweite Zuverlässigkeitsinformation (auch im binären Fall) nicht notwendigerweise in der hier verwendeten als logarithmisches Verhältnis von Wahrscheinlichkeiten (sogenannte LLR-(Log-Likelihood Ratio-) Darstellung) an den Ausgängen O1 und O2 des DEC bereitgestellt werden muß.

An einem dritten (optionalen) Ausgang 03 des DECs kann auf der Grundlage der Empfangsfolge E und gegebenenfalls des a-priori-Wissens $L_A(U)$ eine Folge

$$\hat{U} = (\hat{u}_1, ..., \hat{u}_N) \tag{16}$$

von "harten" Schätzwerten $\hat{u}_n = 0, 1; n = 1, ..., N$ für die Werte $u_n$ der ursprünglichen Eingangsfolge U ausgegeben werden.

Für die Decodierung ist nun entscheidend, nach welcher Rechenvorschrift die ersten $\Lambda_U$ und zweiten $\Lambda_C$ Zuverlässigkeitsinformationen erzeugt werden.

Im folgenden wird eine erfindungsgemäße Rechenvorschrift für die Bestimmung der ersten $\Lambda_U$ und zweiten $\Lambda_C$ Zuverlässigkeitsinformation angegeben:

Zunächst werden in dem Faltungsdecodierer DEC in üblicher Weise die Metrikinkremente

$$\mu_n^i (E, m', m) \tag{17}$$

zwischen den im Trellis-Diagramm mit einer Verbindungslinie verbundenen Zuständen m und m' berechnet. Dabei bezeichnet n den Zeitpunkt und i den Wert (0 oder 1) eines Bits der Eingangsfolge U des Codierers, d.h. $u_n = i$.

Die Metrikinkremente $\mu_n^i$ (E, m', m) hängen wegen E von den Übertragungseigenschaften des Übertragungskanals (Mobilfunkkanals) ab. Für den Fall eines "gedächnislosen" Gaußschen Übertragungskanals, d.h. eines sog. AWGN- (Additive White Gaussian Noise-) Kanals, bei dem der Einfuß des Kanals auf aufeinanderfolgende Symbole der Ausgangsfolge unabhängig voneinander ist (was gegebenenfalls auch durch Verschachtelung erreicht werden kann), können die Metrikinkremente beispielsweise folgendermaßen bestimmt werden:

$$\mu_n^i \ (E, \ m', \ m) \ = \ \left\{ \frac{a_n}{\sigma^2} \, x_n \ + \ \frac{1}{\sigma_L^2} \, L_A (u_n) \right\} (2i-1) \ + \ \frac{a_n}{\sigma^2} \, y_{1,n} \, (2 \, r_{1,n} \ - \ 1)$$

$$(18)$$

wobei $\sigma^2$ die Varianz des Gaußschen Rauschens ist, $a_n$ die reelle Amplitude von en ist, $\sigma_L^2$ die Varianz der extrinsischen Information $L_A(u_n)$ ist, i die hypothethische uncodierte Information (d.h. 0 oder 1) ist, $r_{1,n}$ die in Gl. (2) definierte erzeugte Redundanz des ersten Codierers ist und $y_{1,n}$ die entsprechende, gestört empfangene Redundanz nach Gl. (10a) ist.

Ferner werden die Vorwärtsrekursionswerte

$$\delta_n \ (m) \ := \ \max_{m' \prec m} \ \left\{ \mu_n^1 \ (E, \ m', \ m) \ + \ \delta_{n-1} \ (m') \ , \ \mu_n^0 \ (E, \ m', \ m) \ + \ \delta_{n-1} \ (m') \right\}$$

$$(19a)$$

und die Rückwärtsrekursionswerte

$$\varepsilon_n \ (m) \ := \ \max_{m' \succ m} \ \left\{ \mu_{n+1}^1 \ (E, \ m, \ m') \ + \ \varepsilon_{n+1} \ (m') \ , \ \mu_{n+1}^0 \ (E, \ m, \ m') \ + \ \varepsilon_{n+1} \ (m') \right\}$$

$$(19b)$$

berechnet, wobei m' $\prec$ m alle m' umfaßt, die im Trellis-Diagramm Vorgänger(zustände) von m sind, und m'$\succ$ m alle m' umfaßt, die im Trellis-Diagramm Nachfolger (zustände) von m sind.

Anschließend werden die Schätzwerte für die erste Zuverlässigkeitsinformation

$$\Lambda(u_n) \ = \ \max_{m \Leftrightarrow m'} \left\{ \delta_n \ (m) \ + \ \mu_n^1 \ (E, \ m, \ m') \ + \ \varepsilon_{n+1} \ (m') \right\}$$

$$- \ \max_{m \Leftrightarrow m'} \left\{ \delta_n \ (m) \ + \ \mu_n^0 \ (E, \ m, \ m') \ + \ \varepsilon_{n+1} \ (m') \right\} \qquad (20)$$

berechnet. Dabei bezeichnet die Abkürzung m $\Leftrightarrow$ m' die Menge aller Zustände m, m', die zu gültigen Übergängen im Trellis-Diagramm gehören.

Nachstehend wird auf die Berechnung der Schätzwerte für die zweite Zuverlässigkeitsinformation $\Lambda_c$ einge-gangen:

Da sich bei dem hier betrachteten systematischen Code die Ausgangsfolge C der codierten Symbole aus der (unveränderten) Eingangsfolge U und der "eingestreuten" Redundanzfolge R zusammensetzt, genügt zur Berechnung von $\Lambda_c$ die Berechnung der darin enthaltenen Folge von zweiter Zuverlässigkeitsinformation $\Lambda_R = (\Lambda(r_1), ..., \Lambda(r_N))$.

Eine lediglich beispielhafte und nicht von der Erfindung umfaßte Berechnung der Schätzwerte für die zweite

Zuverlässigkeitsinformation $\Lambda_R$ kann folgendermaßen durchgeführt werden:

$$\Lambda(r_n) = \max_{m \Leftrightarrow m'} \left\{ \delta_n(m) + \mu_n^{r_n=1}(E, m, m') + \varepsilon_{n+1}(m') \right\}$$
$$- \max_{m \Leftrightarrow m'} \left\{ \delta_n(m) + \mu_n^{r_n=0}(E, m, m') + \varepsilon_{n+1}(m') \right\} \qquad (21)$$

Dabei ist $r_n$ das zum Zeitpunkt n (d.h. durch $u_n$) erzeugte Redundanzbit in der Ausgangsfolge C.

Gemäß der Vorliegenden Erfindung wird die zweite Zuverlässigkeitsinformation jedoch nach der Rechenvorschrift

$$\Lambda(r_n) = \text{sign} \left( \Lambda(u_n) \cdot \Lambda(u_{n-1}) \cdot \dots \cdot \Lambda(u_{n-L+1}) \right)_{RPT} \max_{RPT} \left\{ \Lambda(u_n), \Lambda(u_{n-1}), \dots, \Lambda(u_{n-L+1}) \right\}$$
$$(22)$$

bestimmt.

Dieser Rechenvorschrift liegt zugrunde, daß sich ein codiertes (Redundanz-)Bit $r_n$ stets als Summe über L uncodierte Bits $u_n$, $u_{n-1}$, ..., $u_{n-L+1}$ schreiben läßt. Daher läßt sich die zweite Zuverlässigkeitsinformation nach der Gl. 22 allein aus Produkttermen der ersten Zuverlässigkeitsinformation berechnen. RPT bezeichnet dabei die Menge aller "relevanten Produktterme", welche von dem gewählten Code abhängig ist.

Im folgenden wird die Menge RPT in beispielhafter Weise für zwei spezielle Codes angegeben:

Durch den in Fig. 2a dargestellten (nicht-rekursiven) Codierer wird ein nicht-rekursiver Code der Rückgriffstiefe L = 5 erzeugt. Bezüglich dieses Codes ist die zweite Zuverlässigkeitsinformation bestimmt durch

$$\Lambda(r_n) = \text{sign} \left( \Lambda(u_n) \cdot \Lambda(u_{n-4}) \right) \max \left\{ \Lambda(u_n), \Lambda(u_{n-4}) \right\}, \qquad (22a)$$

d.h. die Menge RPT der relevanten Produktterme umfaßt hier den L-ten und den (L-4)-ten Term der ersten Zuverlässigkeitsinformation, da sich ein codiertes Bit $r_n$ als Summe der uncodierten Bits $u_n$ und $u_{n-4}$ schreiben läßt.

Für den in Fig. 2 dargestellten rekursiven Faltungscodierer RSC1 (Rückgriffstiefe ebenfalls L = 5) bestimmt sich die zweite Zuverlässigkeitsinformation auf rekursive Weise gemäß

$$\Lambda(r_n) = \text{sign} \left( \Lambda(a_n) \cdot \Lambda(a_{n-4}) \right) \max \left\{ \Lambda(a_n), \Lambda(a_{n-4}) \right\}$$

mit der Rekursionsvorschrift

$$\Lambda(a_n) = \text{sign} \left( \Lambda(u_n) \cdot \Lambda(a_{n-1}) \cdot \dots \cdot \Lambda(a_{n-4}) \right) \max \left\{ \Lambda(u_n), \Lambda(a_{n-1}), \dots, \Lambda(a_{n-4}) \right\},$$
$$(22b)$$

da sich ein codiertes Bit $r_n$ (entspricht in der Notation von Gl. 2 dem Bit $r_{1,n}$) als Summe der Zustände $a_n$ und $a_{n-4}$ des Schieberegisters schreiben läßt.

Fig. 4 zeigt ein Blockdiagramm eines Turbo-Decodierers TDEC, der zwei Faltungsdecodierer DEC1, DEC2 nach der Erfindung umfaßt.

In einem Demultiplexer DMUX wird die Empfangsfolge E in die einzelnen Empfangsfolgen X (systematischen Information), Y1 (Redundanz von RSC1) und Y2 (Redundanz von RSC2) aufgetrennt.

Die Folgen X und Y1 werden dem ersten Eingang I1 eines ersten Faltungsdecodierers DEC1 zugeführt. Der Faltungsdecodierer DEC1 entspricht im wesentlichen dem in Fig. 3 gezeigten Faltungsdecodierer DEC, wobei hier der erste Eingang I1 aufgrund des vorgeschalteten Demultiplexers DMUX nicht die gesamte Empfangsfolge E sondern nur die (bereits getrennten) Teilfolgen X und Y1 empfängt.

An dem zweiten Eingang I2 des ersten Faltungsdecodierers DEC1 liegt extrinsische Information $L_A(U)$ an, die ausschließlich von der Empfangsfolge U abhängt und auf erste Zuverlässigkeitsinformation zurückgeht, die von dem zweiten Faltungsdecodierer DEC2 ausgegeben wird.

Von dem ersten Faltungsdecodierer DEC1 erzeugte, beispielsweise nach Gl. 20 berechnete erste Zuverlässigkeitsinformation wird mit $\Lambda1_U$ bezeichnet und an dem ersten Ausgang O1 von DEC1 bereitgestellt. Von dem ersten Faltungsdecodierer DEC1 erzeugte zweite Zuverlässigkeitsinformation wird mit $\Lambda1_c$ bezeichnet, erfindungsgemäß nach Gl. 22 (bzw. Gl. 22a,b) berechnet und an dem zweiten Ausgang 02 von DEC1 bereitgestellt.

Die erste Zuverlässigkeitsinformation $\Lambda1_U$ wird über einen Addierer AD1, dessen anderer invertierender Addiereingang mit $L_A(U)$ verbunden ist, und über einen Verschachteler IL1 dem zweiten Eingang I2 des zweiten Faltungsdecodierers DEC2 als extrinsische Information eingegeben. An dem ersten Eingang I1 des zweiten Decodierers DEC2 liegt die Empfangs-Redundanzteilfolge Y2 sowie die ggf. zuvor in einem Verschachteler IL2 verschachtelte systematische Empfangsfolge X an.

Die von dem zweiten Faltungsdecodierer DEC2 erzeugte erste Zuverlässigkeitsinformation wird mit $\Lambda2_U$ bezeichnet, beispielsweise nach Gl. 20 berechnet und am ersten Ausgang O1 von DEC2 bereitgestellt. Die von dem zweiten Faltungsdecodierer DEC2 erzeugte zweite Zuverlässigkeitsinformation wird mit $\Lambda2_C$ bezeichnet, erfindungsgemäß nach Gl. 22 (bzw. Gl. 22a,b) berechnet und an dem zweiten Ausgang 02 von DEC2 bereitgestellt.

Die erste Zuverlässigkeitsinformation $\Lambda2_U$ von DEC2 wird einem Addierer AD2 eingegeben, dessen anderer invertierender Eingang mit dem zweiten Eingang I2 des zweiten Faltungsdecodierers DEC2 in Verbindung steht. Ausgangsseitig ist der Addierer AD2 mit dem Eingang eines Entschachtelers DIL1 verbunden, dessen Ausgang die bereits erwähnte extrinsische Information $L_A(U)$ für den ersten Faltungsdecodierer DEC1 bereitstellt.

Die erste Zuverlässigkeitsinformation $\Lambda2_U$ von DEC2 wird ferner zur Ermittlung einer Folge von Schätzwerten $\hat{U} = (\hat{u}_1, ..., \hat{u}_N)$ für die Eingangsfolge U verwendet. Hierzu wird $\Lambda2_U$ einer Schwellenwertlogik TL zugeleitet, die bei $\Lambda2_U(u_n) \leq 0$ entscheidet, daß $\hat{u}_n = 0$ ist und bei $\Lambda2_U(u_n) > 0$ entscheidet, daß $\hat{u}_n = 1$ ist.

Der Ausgang der Schwellenwertlogik TL ist mit einem Entschachteler DIL2 verbunden, welcher die Folge $\hat{U}$ in der richtigen Symbolabfolge ausgibt.

Die erfindungsgemäß bestimmten zweiten Zuverlässigkeitsinformationen $\Lambda1_c$ und $\Lambda2_c$ werden zur Ermittlung einer kombinierten Zuverlässigkeitsinformation aus extrinsischen Daten ED verwendet, welche benötigt wird, um eine "Turbo-Entzerrung" zu ermöglichen. Eine Turbo-Entzerrung kann durch eine iterative Kombination eines Entzerrers mit dem in Fig. 4 gezeigten Turbo-Decodierer TDEC erreicht werden (siehe Fig. 5).

Zur Ermittlung von ED wird $L_A(U)$, $\Lambda1_C$ und $\Lambda2_C$ jeweils Addierern AD3, AD4 bzw. AD5 zugeleitet, deren jeweils anderer, invertierender Eingang mit X, Y1 bzw. Y2 verbunden ist. Die Ausgänge der Addierer AD3, AD4 und AD5 werden in einer Logigstufe C geeignet kombiniert, wobei die extrinsischen Daten ED gebildet werden.

Fig. 5 zeigt in schematischer Weise den Aufbau einer Empfängerstruktur TEQU, die eine Turbo-Entzerrung realisiert.. Ein adaptiver Entzerrer (bestehend aus einem Kanalschätzer und einem Datendetektor) EQU empfängt an einem ersten Eingang ursprüngliche Empfangsdaten $\tilde{E}$, die von einer nicht dargestellten Demodulatorstufe (Mischer, A/D-Umsetzer, Filter) eines HF-Empfängers ausgegeben werden. Der Entzerrer EQU ermittelt fortlaufend anhand ihm bekannter Trainingssequenzen im ausgesendeten Signal die aktuellen Kanalübertragungsparameter (Kanalimpulsantworten) des Mobilfunkkanals und führt mit Hilfe der ermittelten aktuellen Kanalübertragungsparameter die Datendetektion der (zu diesem Zeitpunkt noch verschachtelten) Symbole der ursprünglichen Empfangsfolge $\tilde{E}$ durch.

Von dem Entzerrer EQU ausgegebene Daten werden einem ersten Eingang eines Addierers AD6 zugeführt, dessen Ausgang mit dem Eingang eines Blockentschachtelers BDIL verbunden ist. Am Ausgang des Blockentschachteler BDIL liegen die rekonstruierten Symbole der Ausgangsfolge C, d.h. die Empfangsfolge E, vor. Diese wird, wie bereits beschrieben, dem Turbo-Decodierer TDEC zugeführt.

Die von dem Turbo-Decodierer TDEC erzeugten extrinsischen Daten ED werden über einen Blockverschachteler BIL einem zweiten Eingang des Addierers AD6 sowie einem für extrinsische Information bestimmten Eingang des Entzerrers EQU zurückgekoppelt. Der geringe Rechenaufwand bei der Berechnung der zweiten Zuverlässigkeitsinformation ermöglicht, daß die iterative Entzerrung in vertretbarer Zeit durchgeführt werden kann.

Bezugszeichenliste

| | |
|---|---|
| U | Eingangsfolge |
| C | Ausgangsfolge |
| TCOD | Turbo-Codierer |
| IL | Verschachteler |
| RSC1/2 | RSC-Codierer |
| PKT1/2 | Punktierer |
| R1/2 | Redundanz-Teilfolge |

MUX         Multiplexer
ADD1/2    Addierer
T           Zelle eines Schieberegisters
I1         erster Eingang
I2         zweiter Eingang
O1        erster Ausgang
O2        zweiter Ausgang
03        dritter Ausgang
DEC      Faltungsdecodierer
$L_A(U)$    a-priori-Wissen über U
$\Lambda_U$        erste Zuverlässigkeitsinformation
$\Lambda_C$        zweite Zuverlässigkeitsinformation
TDEC    Turbo-Decodierer
DMUX   Demultiplexer
DEC1/2   Faltungsdecodierer
IL1/2     Verschachteler
DIL1/2    Entschachteler
AD1-6    Addierer
TL         Schwellenwertlogik
C           Kombinationslogik
TEQU    Turbo-Entzerrer
EQU      Entzerrer
BIL        Blockverschachteler
BDIL     Blockentschachteler
ED        extrinsische Daten

**Patentansprüche**

**1.** Verfahren zur Decodierung von Faltungscodes, denen ein Codierprozeß zugrundeliegt, in welchem aus einer Folge (U) von uncodierten Symbolen ($u_1$, $u_2$, ..., $u_N$) durch Hinzufügen von Redundanz (R1, R2; R ) eine Folge (C) von codierten Symbolen ($c_1$, $c_2$, ..., $c_K$) erzeugt wird, das die Schritte umfaßt:

- Entgegennahme einer Folge (E) von empfangenen codierten Symbolen ($e_1$, $e_2$, ..., $e_K$) ;
- Berechnung einer ersten Zuverlässigkeitsinformation ($\Lambda_U(u_n)$) für jedes uncodierte Symbol ($u_n$), welche repräsentativ für die Wahrscheinlichkeit ist, daß das betrachtete n-te uncodierte Symbol ($u_n$) der Folge (U) von uncodierten Symbolen gleich einem Wert i des Symbolvorrats ist unter der Bedingung, daß die Folge (E) von empfangenen codierten Symbolen vorliegt;
- Berechnung einer zweiten Zuverlässigkeitsinformation ($\Lambda_C(c_k)$) für jedes codierte Symbol ($c_k$), welche repräsentativ für die Wahrscheinlichkeit ist, daß das betrachtete k-te codierte Symbol ($c_k$) der Folge (C) von codierten Symbolen gleich einem Wert i des Symbolvorrats ist unter der Bedingung, daß die Folge (E) von empfangenen codierten Symbolen ($e_1$, $e_2$, ..., $e_K$) vorliegt;

**dadurch gekennzeichnet,**
**daß** die zweite Zuverlässigkeitsinformation ($\Lambda_C(c_k)$) durch die Ermittlung des Maximalwertes von codeabhängigen Produkttermen der ersten Zuverlässigkeitsinformation ($\Lambda_U(u_n)$) bestimmt wird.

**2.** Verfahren nach Anspruch 1,
**dadurch gekennzeichnet,**

- **daß** zur Berechnung der ersten Zuverlässigkeitsinformation zunächst Metrikinkremente $\mu_n^i$ (E, m, m'), Vorwärtsrekursionswerte $\delta_n$ (m) und Rückwärtsrekursionswerte $\varepsilon_{n+1}(m')$ bezüglich gültiger Übergänge zwischen Zuständen m, m' des beim Codierprozeß verwendeten Codierers (TCOD) berechnet werden, und
- **daß** die erste Zuverlässigkeitsinformation durch die Ermittlung der Maximalwerte von Ausdrücken der Form

$$\left\{ \delta_n(m) + \mu_n^i(E,\, m,\, m') + \varepsilon_{n+1}(m') \right\}.$$

bestimmt wird, wobei i der Wert des n-ten uncodierten Symbols ($u_n$) ist.

3. Verfahren nach einem der vorhergehenden Ansprüche,
   **dadurch gekennzeichnet,**

   - **daß** ein a-priori-Wissen ($L_A(U)$) über die Folge (U) von uncodierten Symbolen ($u_1, u_2, ..., u_N$) vorhanden ist, und
   - **daß**. das a-priori-Wissen ($L_A(U)$) in die Bestimmung der ersten und/oder zweiten Zuverlässigkeitsinformationen ($\Lambda_U; \Lambda_C$) einbezogen wird.

4. Verfahren nach einem der vorhergehenden Ansprüche,
   **dadurch gekennzeichnet,**
   **daß** es sich bei der Folge (C) von codierten Symbolen ($c_1, c_2, ..., c_K$) um eine die Folge (U) von uncodierten Symbolen ($u_1, u_2, ..., u_N$) enthaltende Folge handelt.

5. Faltungsdecodierer,

   - mit einem ersten Eingang (I1) zur Entgegennahme einer Folge (E) von empfangenen codierten Symbolen ($e_1, e_2, ..., e_K$),
   - mit einem ersten Ausgang (O1) zur Ausgabe von erster Zuverlässigkeitsinformation ($\Lambda_U(u_n)$), und
   - mit einem zweiten Ausgang (02) zur Ausgabe von zweiter Zuverlässigkeitsinformation ($\Lambda_C(c_k)$),

   **dadurch gekennzeichnet, daß** die zweite Zuverlässigkeitsinformation ($\Lambda_C(c_k)$) nach einem der vorhergehenden Ansprüche berechnet wird.

6. Faltungsdecodierer nach Anspruch 5,
   **dadurch gekennzeichnet,**
   **daß** der Faltungsdecodierer (DEC; DEC1, DEC2) einen dritten Ausgang (03) aufweist, an dem er bezüglich jedes uncodierten Symbols ($u_1, u_2, ..., u_N$) einen geschätzten Wert ($\hat{u}_1, \hat{u}_2, ..., \hat{u}_N$) für das uncodierte Symbol ($u_1, u_2, ..., u_N$) aus dem Symbolvorrat bereitstellt.

7. Turbo-Decodierer mit einem ersten und einem zweiten Faltungsdecodierer (DEC1; DEC2), die beide zweite Zuverlässigkeitsinformation ($\Lambda 1_C(c_k)$), ($\Lambda 2_C(c_k)$) erzeugen und von denen wenigstens einer nach Anspruch 5 oder 6 ausgebildet ist,
   **dadurch gekennzeichnet,**

   - **daß** die erste Zuverlässigkeitsinformation ($\Lambda 1_U(u_n)$) des ersten Faltungsdecodierers (DEC1) dem zweiten Faltungsdecodierer (DEC2) als a-priori-Wissen über die Folge (U) der uncodierten Symbole ($u_1, u_2, ..., u_N$) zugeführt wird,
   - **daß** die erste Zuverlässigkeitsinformation ($\Lambda 2_U(u_n)$) des zweiten Faltungsdecodierers (DEC2) dem ersten Faltungsdecodierer (DEC1) als a-priori-Wissen über die Folge (U) der uncodierten Symbole ($u_1, u_2, ..., u_N$) zurückgeführt wird, und
   - **daß** die zweiten Zuverlässigkeitsinformationen ($\Lambda 1_C; \Lambda 2_C$) des ersten Faltungsdecodierers (DEC1) und des zweiten Faltungsdecodierers (DEC2) in einer Logikstufe (C) zu einer kombinierten Zuverlässigkeitsinformation (ED) kombiniert werden.

8. Empfängerstruktur mit einem Turbo-Decodierer nach Anspruch 7,
   **dadurch gekennzeichnet,**
   **daß** der Turbo-Decodierer (TDEC) mit einem Entzerrer (EQU) rückkopplungsmäßig verschaltet ist, derart, daß die kombinierte Zuverlässigkeitsinformation (ED) einem Eingang des Entzerrers (EQU) zugeführt ist.

**Claims**

1. Method for decoding convolutional codes which are based on a coding process in which a sequence (C) of coded symbols ($c_1, c_2, ..., c_k$) is produced from a sequence (U) of uncoded symbols ($u_1, u_2, ..., u_k$) by adding redundancy (R1, R2; R), which method comprises the steps of:

   - accepting a sequence (E) of received coded symbols ($e_1, e_2, ..., e_k$) ;

- calculating a first item of reliability information ($\Lambda_U(u_n)$) for each uncoded symbol ($u_n$), which is representative of the probability that the considered nth uncoded symbol ($u_n$) of the sequence (U) of uncoded symbols is equal to a value i of the symbol set under the condition that the sequence (E) of received coded symbols is present;

- calculating a second item of reliability information ($\Lambda_c(c_k)$) for each coded symbol ($c_k$), which is representative of the probability that the considered kth coded symbol ($c_k$) of the sequence (C) of coded symbols is equal to a value i of the symbol set, under the condition that the sequence (E) of received coded symbols ($e_1$, $e_2$, ..., $e_k$) is present;

**characterized in that** the second item of reliability information ($\Lambda_c(c_k)$) is determined by the determination of the maximum value of code-dependent product terms of the first item of reliability information ($\Lambda_U(u_n)$).

2. Method according to Claim 1, **characterized**

- **in that** in order to calculate the first item of reliability information the first step is to calculate metric increments, $\mu_n^1(E,m,m')$, forward recursion values $\delta_n(m)$ and backward recursion values $\varepsilon_{n+1}(m')$ with reference to valid transitions between states m, m' of the coder (TCOD) used in the coding process, and
- **in that** the first item of reliability information is determined by determining the maximum values of expressions of the form

$$\{\delta_n(m) + \mu_n^i(E,m,m') + \varepsilon_{n+1}(m')\},$$

i being the value of the nth uncoded symbol ($u_n$).

3. Method according to one of the preceding claims, **characterized**

- **in that** a priori knowledge ($L_A(U)$) of the sequence (U) of uncoded symbols ($u_1$, $u_2$, ... $u_N$) is present, and
- **in that** the a-priori knowledge ($L_A(U)$) is incorporated into the determination of the first and/or second items of reliability information ($\Lambda_U$; $\Lambda_c$).

4. Method according to one of the preceding claims, **characterized in that** the sequence (C) of coded symbols ($c_1$, $c_2$, ..., $c_K$) is a sequence containing the sequence (U) of uncoded symbols ($u_1$, $u_2$, ..., $u_N$).

5. Convolutional decoder,

- having a first input (I1) for accepting a sequence (E) of received coded symbols ($e_1$, $e_2$, ..., $e_K$),
- having a first output (O1) for outputting a first item of reliability information ($\Lambda_U(u_n)$), and
- having a second output (02) outputting a second item of reliability information ($\Lambda_c(c_k)$,

**characterized in that** the second item of reliability information ($\Lambda_c(c_k)$ is calculated according to one of the preceding claims.

6. Convolutional decoder according to Claim 5, **characterized in that** the convolutional decoder (DEC; DEC1, DEC2) has a third output (03) at which it provides with reference to each uncoded symbol ($u_1$, $u_2$, ..., $u_N$) an estimated value ($\hat{u}_1$, $\hat{u}_2$, ..., $\hat{u}_N$) for the uncoded symbol ($u_1$, $u_2$, ..., $u_N$) from the symbol set.

7. Turbo decoder having a first and a second convolutional decoder (DEC1; DEC2) which both produce a second item of reliability information ($\Lambda1_c(c_k)$, ($\Lambda2_c(c_k)$), and of which at least one is designed according to Claim 5 or 6, **characterized**

- **in that** the first item of reliability information ($\Lambda1_U(u_n)$) of the first convolutional decoder (DEC1) is fed to the second convolutional decoder (DEC2) as a priori knowledge of the sequence (U) of the uncoded symbols ($u_1$, $u_2$, ..., $u_N$),
- **in that** the first item of reliability information ($\Lambda2_u(u_n)$) of the second convolutional decoder (DEC2) is fed back to the first convolutional decoder (DEC1) as a priori knowledge of the sequence (U) of the uncoded symbols ($u_1$, $u_2$, ... $u_N$), and
- **in that** the second items of reliability information ($\Lambda1_c$; $\Lambda2_c$) of the first convolutional decoder (DEC1) and of the second convolutional decoder (DEC2) are combined in a logic stage (C) to form a combined item of reliability information (ED).

8. Receiver structure having a turbo decoder according to Claim 7, **characterized in that** the turbo decoder (TDEC) is connected up to an equalizer (EQU) in terms of feedback in such a way that the combined item of reliability information (ED) is fed to an input of the equalizer (EQU).

**Revendications**

1. Procédé pour le décodage de codes de convolution basés sur un processus de codage, dans lequel on produit à partir d'une séquence (U) de symboles non codés ($u_1$, $u_2$, ..., $u_N$) par ajout de redondance (R1, R2 ; R) une séquence (C) de symboles codés ($c_1$, $c_2$, ..., $c_K$), comprenant les étapes suivantes :

   - réception d'une séquence (E) de symboles codés reçus ($e_1$, $e_2$, ..., $e_K$) ;
   - calcul d'une première information de fiabilité ($\Lambda_U$ ($u_n$)) pour chaque symbole non codé ($u_n$) qui est représentative de la probabilité pour que le n-ème symbole non codé considéré ($u_n$) de la séquence (U) de symboles non codés soit égal à la valeur i de la réserve de symboles à la condition que la séquence (E) de symboles codés reçus soit présente ;
   - calcul d'une deuxième information de fiabilité ($\Lambda_C$ ($c_k$)) pour chaque symbole codé ($c_k$) qui est représentative de la probabilité pour que le k-ème symbole codé considéré ($c_k$) de la séquence (C) de symboles codés soit égal à une valeur i de la réserve de symboles à la condition que la séquence (E) de symboles codés reçus ($e_1$, $e_2$, ..., $e_K$) soit présente ;

   **caractérisé par le fait qu'**on détermine la deuxième information de fiabilité ($\Lambda_C$ ($c_k$)) en déterminant la valeur maximale de termes de produits, dépendant du code, de la première information de fiabilité ($\Lambda_U$ ($u_n$)).

2. Procédé selon la revendication 1,
   **caractérisé par le fait que**

   - pour le calcul de la première information de fiabilité, on calcule d'abord des incréments métriques $\mu_n^i$ (E, m', m), des valeurs de récurrence en avant $\delta_n$ (m) et des valeurs de récurrence en arrière $\varepsilon_{n+1}$ (m') par rapport à des transitions valides entre des états m, m' du codeur (TCOD) utilisé lors du processus de codage, et
   - on détermine la première information de fiabilité en déterminant les valeurs maximales d'expressions de la forme

$$\{\delta_n\ (m) + \mu_n^i\ (E, m, m') + \varepsilon_{n+1}\ (m')\},$$

   i étant la valeur du n-ème symbole non codé ($u_n$).

3. Procédé selon l'une des revendications précédentes,
   **caractérisé par le fait que**

   - il existe une connaissance a priori ($L_A$ (U)) sur la séquence (U) de symboles non codés ($u_1$, $u_2$, ..., $u_N$), et
   - on inclut la connaissance a priori ($L_A$ (U)) dans la détermination des premières et/ou deuxièmes informations de fiabilité ($\Lambda_U$ ; $\Lambda_C$).

4. Procédé selon l'une des revendications précédentes,
   **caractérisé par le fait que**
   la séquence (C) de symboles codés ($c_1$, $c_2$, ..., $c_K$) est une séquence contenant la séquence (U) de symboles non codés ($u_1$, $u_2$, ..., $u_N$).

5. Décodeur de convolution, comportant

   - une première entrée (I1) pour la réception d'une séquence (E) de symboles codés reçus ($e_1$, $e_2$, ..., $e_K$),
   - une première sortie (O1) pour la délivrance d'une première information de fiabilité ($\Lambda_U$ ($u_n$)), et
   - une deuxième sortie (02) pour la délivrance d'une deuxième information de fiabilité ($\Lambda_C$ ($c_k$)),

**caractérisé par le fait que** la deuxième information de fiabilité ($\Lambda_C$ ($c_k$)) est calculée selon l'une des revendications précédentes.

6. Décodeur de convolution selon la revendication 5,
**caractérisé par le fait que** le décodeur de convolution (DEC ; DEC1, DEC2) comporte une troisième sortie (O3) à laquelle il fournit, par rapport à chaque symbole non codé ($u_1$, $u_2$, ..., $u_N$), une valeur estimée ($\hat{u}_1$, $\hat{u}_2$, ..., $\hat{u}_N$) pour le symbole non codé ($u_1$, $u_2$, ..., $u_N$) prise dans la réserve de symboles.

7. Turbo-décodeur comportant un premier et un deuxième décodeur de convolution (DEC1 ; DEC2) qui produisent tous les deux une deuxième information de fiabilité ($\Lambda 1_C$ ($c_k$), $\Lambda 2_C$ ($c_k$)) et dont au moins l'un est conçu selon la revendication 5 ou 6,
**caractérisé par le fait que**

- la première information de fiabilité ($\Lambda 1_U$ ($u_n$)) du premier décodeur de convolution (DEC1) est envoyée comme connaissance a priori sur la séquence (U) des symboles non codés ($u_1$, $u_2$, ..., $u_N$) au deuxième décodeur de convolution (DEC2),
- la première information de fiabilité ($\Lambda 2_U$ ($u_n$)) du deuxième décodeur de convolution (DEC2) est envoyée comme connaissance a priori sur la séquence (U) des symboles non codés ($u_1$, $u_2$, ..., $u_N$) au premier décodeur de convolution (DEC1), et
- les deuxièmes informations de fiabilité ($\Lambda 1_C$ ; $\Lambda 2_C$) du premier décodeur de convolution (DEC1) et du deuxième décodeur de convolution (DEC2) sont combinées dans un étage logique (C) pour donner une information de fiabilité combinée (ED).

8. Structure de récepteur comportant un turbo-décodeur selon la revendication 7,
**caractérisée par le fait que** le turbo-décodeur (TDEC) est branché pour une rétroaction avec un égaliseur (EQU) de telle sorte que l'information de fiabilité combinée (ED) est envoyée à une entrée de l'égaliseur (EQU).

Fig. 1

Fig. 2

Fig. 2a

Fig. 3

Fig. 4

Fig. 5